# EUROPEAN PATENT APPLICATION

(11) **EP 3 236 503 A1**
(43) Date of publication of application: **25.10.2017**
(21) Application number: 16165832.3
(22) Date of filing: 18.04.2016
(51) Int. Cl.: H01L 29/66, H01L 29/786, H01L 29/423

(54) **METHOD FOR FABRICATING FULLY SELF-ALIGNED DUAL-GATE THIN FILM TRANSISTORS**

(71) Applicant: IMEC VZW, 3001 Leuven (BE); Nederlandse Organisatie voor toegepast- natuurwetenschappelijk onderzoek TNO, 2595 DA 's-Gravenhage (NL)
(72) Inventor: Nag, Manoj, 3001 Leuven (BE)
(74) Representative: Patent Department IMEC

(57) **Abstract**

The present disclosure provides a method for fabricating a fully self-aligned dual-gate metal oxide semiconductor thin film transistor The method comprises: providing on a front side of a substrate a first gate electrode delimiting a gate region; providing a first gate dielectric layer; providing a patterned metal oxide semiconductor layer; providing a second gate dielectric layer; providing a second gate electrically conductive layer; providing a photoresist layer; patterning the photoresist layer; patterning the second gate electrically conductive layer, thereby forming a second gate electrode; and patterning the second gate dielectric layer. Patterning the photoresist layer comprises performing a rear side illumination step, a front side illumination step and a photoresist development step, wherein the rear side illumination step comprises illumination of the photoresist layer from a rear side of the substrate using the first gate electrode as a mask, and wherein front side illumination step comprises illumination of the photoresist layer from the front side using a mask exposing the photoresist layer in the gate region only in an edge part.

## Description

### Field

The present disclosure relates to methods for fabricating amorphous metal oxide semiconductor thin film transistors. More in particular, the present disclosure relates to methods for fabricating fully self-aligned dual-gate thin film transistors.

### State of the art

In recent years, amorphous metal oxide semiconductors, such as for example amorphous Indium Gallium Zinc Oxide (IGZO), have received great interest as a material for Thin Film Transistor (TFT) applications. These materials have been investigated as an alternative to amorphous silicon (a-Si:H) and low temperature polycrystalline silicon (LTPS) TFTs, for example in the context of active matrix liquid crystal displays (AMLCDs) and active matrix organic light emitting diode displays (AMOLEDs).

For enhancing the performance of TFT based electronic systems, high-speed operation is required. Common solutions to improve the speed performance are the use of high mobility materials and the reduction of the transistor channel length (L). Another solution to achieve enhanced performance is the use of a dual-gate (DG) transistor structure. In the context of TFT architectures, the self-aligned (SA) Gate-Source/Drain TFT structure, wherein a gate is self-aligned to the source and drain, has zero gate-source/drain overlap capacitance, in contrast with back-channel-etch (BCE) and etch-stop-layer (ESL) structures, and a smaller footprint when compared to ESL structures. It has been reported that for a-IGZO TFT circuits with dual-gate (DG) operation better control of the channel is achieved, resulting in improved characteristics such as higher mobility, higher on-current (I_{ON}), smaller sub-threshold slope (SS⁻¹) and a turn-on voltage (V_{ON}) closer to zero Volt.

A method for fabricating fully self-aligned dual-gate a-IGZO TFTs is disclosed by Xin He et al in "Implementation of Fully Self-Aligned Homojunction Double-Gate a-IGZO TFTs", IEEE Electron Device Letters, Vol. 35, No. 9. September 2014, pp 927-929. In a fully self-aligned dual-gate TFT, the top gate and the bottom gate are self-aligned to each other and the source and drain are self-aligned to the gates. According to the method described by Xin He et al, self-alignment between the bottom gate and the top gate is realized with a photolithographic step with back-side illumination; self-alignment between the source/drain regions and the two gates is obtained by argon plasma treatment and hydrogen doping. This method requires six photolithographic (PL) steps, i.e. six steps comprising providing a photoresist layer, illuminating the photoresist layer and developing the illuminated resist. In a first step, a first gate metallic layer (bottom gate or back gate metallic layer) is deposited on a glass substrate and patterned (PL#1) by wet etching to form a back gate electrode. Then a first gate dielectric layer is deposited, followed by the deposition of an a-IGZO layer by DC sputtering. The a-IGZO layer is then patterned using wet etching (PL#2). Afterwards a second gate dielectric layer is deposited. Subsequently a negative photoresist layer is provided at the front side and next the wafer is illuminated from the backside (PL#3), for defining the top gate pattern. The top gate pattern is thus defined by the back gate electrode acting as an in-situ mask during back side illumination. After resist development a second gate layer (top gate layer) is deposited and lifted off to form the top gate electrode. Dry etching is used for patterning the second gate dielectric layer, using the top gate as an etching mask. The exposed α-IGZO layer on the source/drain regions is then treated by Ar plasma to enhance the conductivity. Afterwards a SiNₓ layer is deposited, further leading to the formation of n+ a-IGZO source/drain regions that are self-aligned to the top gate electrode. This is followed by opening via holes for the source and drain regions (PL#4) and deposition and patterning (PL#5) of source/drain electrodes. Finally a back gate contact hole is opened (PL#6).

### Summary

It is an object of the present disclosure to provide a method for fabricating fully self-aligned dual-gate thin film transistors wherein the number of process steps is reduced as compared to known methods. More in particular, it is an object of the present disclosure to provide a method for fabricating fully self-aligned dual-gate amorphous metal oxide semiconductor thin film transistors with a reduced number of photolithographic steps as compared to known methods.

The above objective is accomplished by a method according to the present disclosure.

This disclosure is related to a method for fabricating a fully self-aligned dual-gate metal oxide semiconductor thin film transistor. The method comprises: providing on a front side of a substrate a first gate electrode delimiting a gate region; providing a first gate dielectric layer over the substrate and the first gate electrode; providing a patterned metal oxide semiconductor layer on the first gate dielectric layer, the patterned metal oxide semiconductor layer delimiting a semiconductor region partially overlapping with part of the gate region and extending beyond two opposite edges of the gate region; providing a second gate dielectric layer over the patterned metal oxide semiconductor layer; providing a second gate electrically conductive layer; providing a photoresist layer; patterning the photoresist layer, thereby forming a patterned photoresist layer; patterning the second gate electrically conductive layer, thereby forming a second gate electrode; and patterning the second gate dielectric layer, thereby forming a patterned second gate dielectric layer. In a method according to embodiments of the present disclosure, patterning the photoresist layer comprises performing a rear side illumination step, a front side illumination step and a photoresist development step, wherein the rear side illumination step comprises illumination of the photoresist layer from a rear side of the substrate using the first gate electrode as a mask, and wherein front side illumination step comprises illumination of the photoresist layer from the front side using a mask exposing the photoresist layer in the gate region only in an edge part.

In embodiments of a method of the present disclosure, providing the second gate electrically conductive layer may be done before providing the photoresist layer. In such embodiments a positive photoresist layer is used. Patterning the second gate electrically conductive layer then comprises locally etching the second gate electrically conductive layer using the patterned photoresist layer as a mask, and patterning the second gate dielectric layer comprises locally etching the second gate dielectric layer using the patterned photoresist layer or the second gate electrode as a mask.

In other embodiments of a method of the present disclosure, providing the second gate electrically conductive layer may be done after patterning the photoresist layer. In such embodiments a negative photoresist layer is used. Patterning the second gate electrically conductive layer then comprises performing a lift-off process, and patterning the second gate dielectric layer comprises locally etching the second gate dielectric layer using the second gate electrode as a mask.

In embodiments of the present disclosure the edge part is preferably located in a part of the gate region that is non-overlapping with the semiconductor region. In embodiments of the present disclosure the first gate may for example comprise a narrower portion and a wider portion, and the edge part may be located within an area corresponding to a part of the wider portion. In such embodiments the edge part only overlaps with a part of the wider portion of the bottom gate.

A method according to embodiments of the present disclosure may further comprise providing a source region and a drain region in the patterned metal oxide semiconductor layer, wherein the source region and the drain region are self-aligned to the second gate electrode. In the process of providing the source region and the drain region, the second gate electrode may be used as a mask.

Providing the source region and the drain region may for example comprise doping with hydrogen. Providing the source region and the drain region may for example comprise implantation of dopants or plasma treatment or reduction of the metal oxide semiconductor material. Different methods for providing the source region and the drain region may be combined, e.g. performed sequentially. In embodiments of the present disclosure, forming the source region and the drain region may comprise a combination of hydrogen doping, implantation of dopants, plasma treatment and/or reduction of the metal oxide semiconductor material.

A method according to embodiments of the present disclosure may further comprise depositing a dielectric layer and forming vias through the dielectric layer simultaneously towards the source region, the drain region, the second gate electrode and the first gate electrode.

In embodiments of a method according to the present disclosure, depositing the dielectric layer may comprise depositing a silicon nitride layer. In such embodiments the step of depositing the silicon nitride layer may introduce hydrogen in the metal oxide semiconductor layer, thereby doping the metal oxide semiconductor layer with hydrogen and forming the source region and the drain region. Depositing the silicon nitride layer preferably comprises depositing the silicon nitride layer by means of Plasma Enhanced Chemical Vapour Deposition.

A method according to embodiments of the present disclosure may further comprise depositing and patterning an electrically conductive layer, thereby simultaneously forming a source contact, a drain contact, a first gate contact and a second gate contact.

It is an advantage of a method according to embodiments of the present disclosure that it allows fabricating fully self-aligned dual-gate thin film transistors with a reduced number of process steps, more in particular a reduced number of photolithographic steps, as compared to known methods. It is an advantage that this may result in a reduced manufacturing cost of fully self-aligned dual-gate thin film transistors. It is an advantage that this may result in a reduced complexity of the method as compared to known methods.

Particular and preferred aspects of the disclosure are set out in the accompanying independent and dependent claims. Features from the dependent claims may be combined with features of the independent claims and with features of other dependent claims as appropriate and not merely as explicitly set out in the claims.

The above and other characteristics, features and advantages of the present disclosure will become apparent from the following detailed description, taken in conjunction with the accompanying drawings, which illustrate, by way of example, the principles of the disclosure. This description is given for the sake of example only, without limiting the scope of the disclosure. The reference figures quoted below refer to the attached drawings.

### Brief description of the figures

FIG 1 schematically illustrates an example of a process flow in accordance with an embodiment of a method of the present disclosure.

FIG 2 schematically illustrates an example of a process flow in accordance with an embodiment of a method of the present disclosure.

FIG 3 to FIG 8 schematically illustrate process steps of an example of a method for fabricating a fully self-aligned dual-gate thin film transistor in accordance with an embodiment of the present disclosure. A schematic top view of the structure is shown at the left hand side and schematic cross sections along line A-A' and along line B-B' respectively are shown at the right hand side.

FIG 9 schematically illustrates an example of a process flow for fabricating a fully self-aligned dual-gate thin film transistor in accordance with a method of the present disclosure.

FIG 10 shows I_{DS} versus V_{GS} transfer characteristics measured for a fully self-aligned dual-gate thin film transistor fabricated according to an embodiment of a method of the present disclosure (circles). As a reference, similar characteristics are shown for devices with back gate only (triangles) and for devices with top gate only (squares).

FIG 11 shows I_{DS} versus V_{DS} output characteristics measured for a fully self-aligned dual-gate thin film transistor fabricated according to an embodiment of a method of the present disclosure (circles). As a reference, similar characteristics are shown for devices with back gate only (triangles) and for devices with top gate only (squares).

In the different figures, the same reference signs refer to the same or analogous elements.

### Detailed description

The present disclosure will be described with respect to particular embodiments and with reference to certain drawings but the disclosure is not limited thereto but only by the claims. The drawings described are only schematic and are nonlimiting. In the drawings, the size of some of the elements may be exaggerated and not drawn on scale for illustrative purposes. The dimensions and the relative dimensions do not correspond to actual reductions to practice of the disclosure.

Moreover, the terms top, bottom, over, under and the like in the description and the claims are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof.

Reference throughout this specification to "one embodiment" or "an embodiment" means that a particular feature, structure or characteristic described in connection with the embodiment is included in at least one embodiment of the present disclosure. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the disclosure, various features of the disclosure are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed disclosure requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this disclosure.

Furthermore, while some embodiments described herein include some but not other features included in other embodiments, combinations of features of different embodiments are meant to be within the scope of the disclosure, and form different embodiments, as would be understood by those in the art. For example, in the following claims, any of the claimed embodiments can be used in any combination.

In the description provided herein, numerous specific details are set forth. However, it is understood that embodiments of the disclosure may be practiced without these specific details. In other instances, well-known methods, structures and techniques have not been shown in detail in order not to obscure an understanding of this description.

The following terms are provided solely to aid in the understanding of the disclosure.

] In the context of the present disclosure, 'self-aligned' means that a first element or feature of a device is aligned to a second element or feature of the device by performing a process wherein the second element or feature is used as a mask for defining the first element or feature. Alignment between two elements or features of the device is thus obtained by using one element or feature as a mask for patterning other elements or features. For example, in the context of a transistor fabrication process a metallic gate may be used as a mask for defining 'self-aligned' source and drain regions of the transistor. For example, in the context of a dual-gate transistor fabrication process, a first gate may be used as a mask for defining a 'self-aligned' second gate.

In the context of the present disclosure, 'fully self-aligned dual-gate thin film transistor (process)' refers to a dual-gate thin film transistor and corresponding fabrication process wherein the gates are self-aligned to each other and wherein the source and drain regions are self-aligned to a gate. More in particular, in the context of the present disclosure the bottom gate is used as a mask for defining (patterning) the top gate, and the top gate is used as a mask for defining the source and drain regions of the thin film transistor.

The disclosure will now be described by a detailed description of several embodiments of the disclosure. It is clear that other embodiments of the disclosure can be configured according to the knowledge of persons skilled in the art without departing from the true spirit or technical teaching of the disclosure, the disclosure being limited only by the terms of the appended claims.

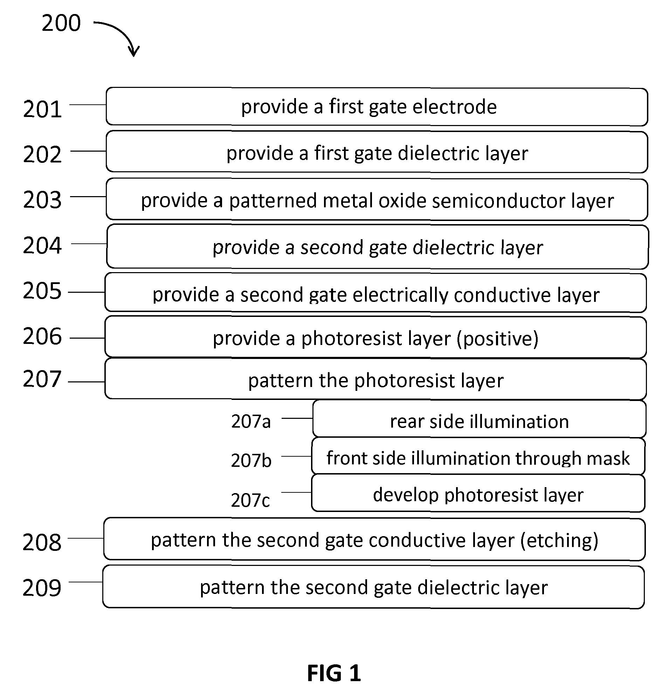

FIG 1 schematically illustrates an example of a process flow in accordance with an embodiment of a method of the present disclosure.

The method 200 shown in the process flow of FIG 1 comprises in a first step (FIG 1, step 201), providing a first gate electrode or bottom gate electrode on a substrate. Providing the first gate electrode or bottom gate electrode comprises depositing a bottom gate metallic layer and patterning the bottom gate metallic layer by means of photolithography to thereby form a first gate electrode or bottom gate electrode. The bottom gate electrode delimits, i.e. defines, a gate region.

In a next step (FIG 1, step 202), a first gate dielectric layer or bottom gate dielectric layer is provided, e.g. deposited, over the substrate and the first gate electrode. Next, a patterned amorphous metal oxide semiconductor layer is provided (FIG 1, step 203) on the first gate dielectric layer. Providing the patterned amorphous metal oxide semiconductor layer comprises depositing an amorphous metal oxide semiconductor layer and patterning this layer by means of photolithography and dry or wet etching. The patterned metal oxide semiconductor layer delimits, i.e. defines, a semiconductor region.

Next, at step 204 (FIG 1), a second gate dielectric layer or top gate dielectric layer is provided over the metal oxide semiconductor layer and afterwards, at step 205 (FIG 1), a second gate electrically conductive layer or top gate electrically conductive layer is provided on the second gate dielectric layer.

After top gate electrically conductive layer deposition, a positive photoresist layer is provided (FIG 1, step 206) on the second gate electrically conductive layer and this photoresist layer is patterned (FIG 1, step 207). Patterning of the photoresist layer is done by performing a rear side illumination step (FIG 1, step 207a), a front side illumination step (FIG 1, step 207b) and a photoresist development step (FIG 1, step 207c), thereby forming a patterned photoresist layer. The rear side illumination step comprises illumination of the photoresist layer from a rear side of the substrate using the first gate electrode as a mask. It is an advantage of using the first gate electrode or bottom gate electrode as a mask that it allows forming a second gate electrode or top gate electrode that is fully aligned with the bottom gate electrode. The front side illumination step comprises illumination of the photoresist layer from the front side of the substrate using a mask exposing the photoresist layer in the gate region only in an edge part, the edge part being non-overlapping with the semiconductor region. The rear side illumination may be done first and afterwards the front side illumination may be done, or vice versa, first the front side illumination may be done and afterwards the rear side illumination.

Next the top gate electrically conductive layer or second gate electrically conductive layer is patterned (FIG 1, step 208) by locally etching the second gate electrically conductive layer using the patterned photoresist layer as a mask, thereby forming a second gate electrode. Further, the top gate dielectric layer or second gate dielectric layer is patterned (FIG 1, step 209) by locally etching the second gate dielectric layer using the patterned photoresist layer or the second gate electrode as a mask.

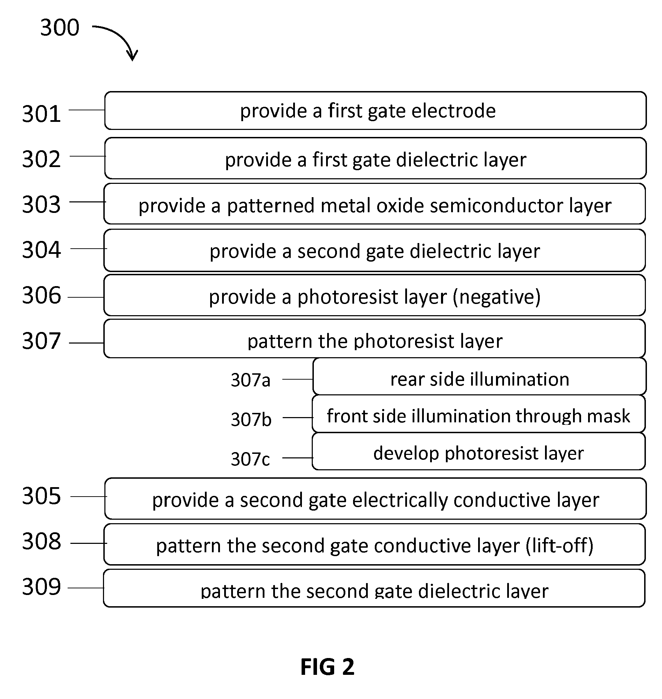

FIG 2 schematically illustrates an example of a process flow in accordance with another embodiment of a method of the present disclosure.

The method 300 shown in the process flow of FIG 2 comprises in a first step (FIG 2, step 301) providing a first gate electrode or bottom gate electrode on a substrate. Providing the first gate electrode or bottom gate electrode comprises depositing a bottom gate metallic layer and patterning the bottom gate metallic layer by means of photolithography to thereby form a first gate electrode or bottom gate electrode. The bottom gate electrode delimits, i.e. defines, a gate region.

In a next step (FIG 2, step 302), a first gate dielectric layer or bottom gate dielectric layer is provided, e.g. deposited, over the substrate and the first gate electrode. Next, a patterned amorphous metal oxide semiconductor layer is provided (FIG 2, step 303) on the first gate dielectric layer. Providing the patterned amorphous metal oxide semiconductor layer comprises depositing an amorphous metal oxide semiconductor layer and patterning this layer by means of photolithography and dry or wet etching. The patterned metal oxide semiconductor layer delimits, i.e. defines, a semiconductor region.

Next, at step 304 (FIG 2), a second gate dielectric layer or top gate dielectric layer is provided over the metal oxide semiconductor layer.

Afterwards a negative photoresist layer is provided (FIG 2, step 306) and this photoresist layer is patterned (FIG 2, step 307). Patterning of the photoresist layer is done by performing a rear side illumination step (FIG 2, step 307a), a front side illumination step (FIG 2, step 307b) and a photoresist development step (FIG 2, step 307c), thereby forming a patterned photoresist layer. The rear side illumination step comprises illumination of the photoresist layer from a rear side of the substrate using the first gate electrode as a mask. It is an advantage of using the first gate electrode or bottom gate electrode as a mask that it allows forming a second gate electrode or top gate electrode that is fully aligned with the bottom gate electrode. The front side illumination step comprises illumination of the photoresist layer from the front side of the substrate using a mask exposing the photoresist layer in the gate region only in an edge part, the edge part being non-overlapping with the semiconductor region. The rear side illumination may be done first and afterwards the front side illumination may be done, or vice versa, first the front side illumination may be done and afterwards the rear side illumination.

After having formed the patterned photoresist layer a second gate electrically conductive layer or top gate electrically conductive layer is provided (FIG 2, step 305). Next the top gate electrically conductive layer or second gate electrically conductive layer is patterned (FIG 2, step 308) by performing a lift-off process, thereby forming a second gate electrode. Further, the top gate dielectric layer or second gate dielectric layer is patterned (FIG 2, step 309) by locally etching the second gate dielectric layer using the second gate electrode as a mask.

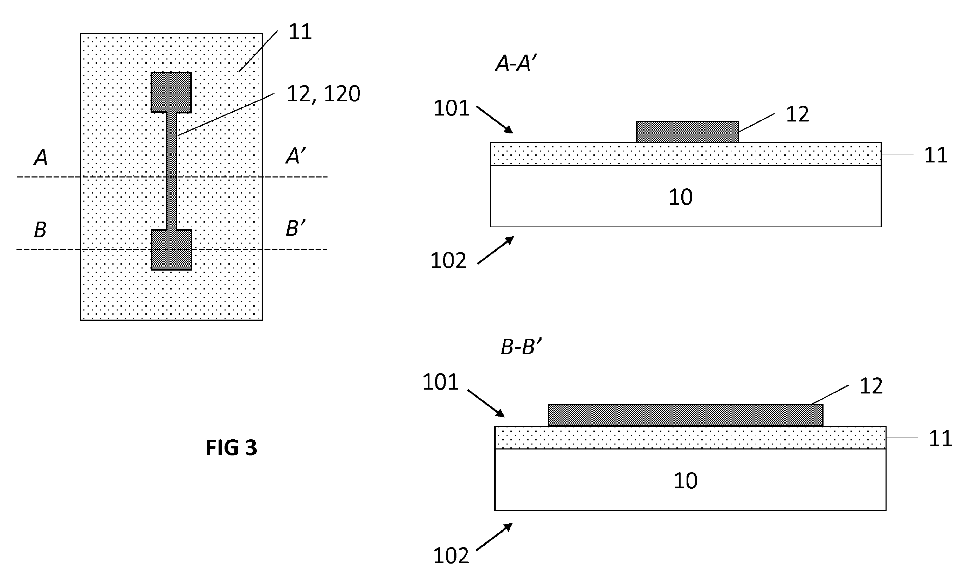

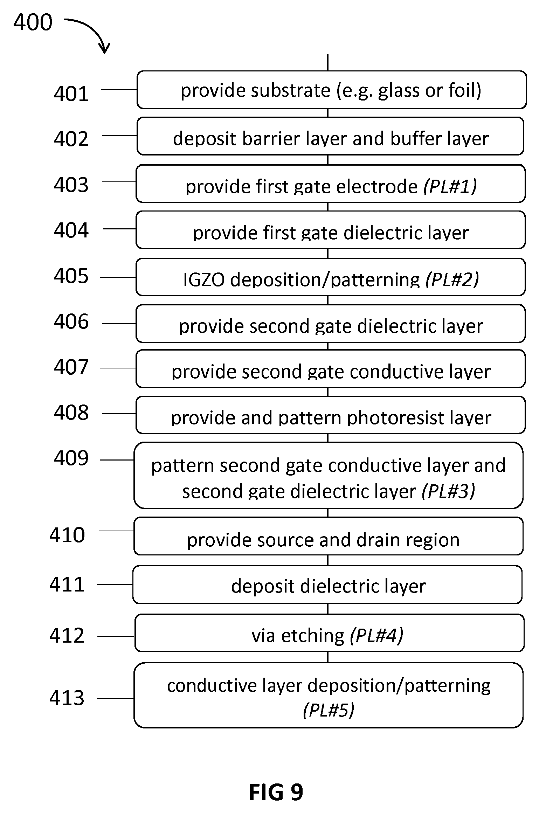

FIG 3 to FIG 8 illustrate an example of a fabrication method of a fully self-aligned dual-gate thin film transistor 100 according to an embodiment of the present disclosure. In these figures, a schematic top view of the fabricated structure is shown at the left hand side and schematic cross sections along line A-A' and along line B-B' respectively are shown at the right hand side. In FIG 3 to FIG 8 the top view is shown at a scale that is different from the scale of the cross sections. The corresponding process flow 400 is schematically illustrated in FIG 9.

In the example shown, the thin-film transistor is formed on a substrate 10, such as for example a glass substrate or a foil substrate. However, the present disclosure is not limited thereto and other substrates may be used, provided they are substantially transparent to the wavelength used for the lithographic step defining the top gate electrode (using illumination through the substrate) as further described. After having provided the substrate 10 (FIG 9, step 401), a buffer layer and optionally a barrier layer are deposited (FIG 9, step 402) on a front side 101 of the substrate 10 as schematically illustrated in FIG 3. In FIG 3 the buffer layer and the barrier layer are shown as a single layer 11. A barrier layer is typically used in combination with a flexible substrate such as a foil substrate, but it may also be used in combination with other substrates such as glass substrates.

In embodiments of the present disclosure, the barrier layer and the buffer layer are dielectric layers. The barrier layer may for example be a silicon nitride layer or a polymer layer, e.g. having a thickness in the range between 100 nm and a 3 micrometer, the present disclosure not being limited thereto. The barrier layer protects the device from undesired influences from the substrate, e.g. from undesired diffusion of elements such as for example hydrogen from the substrate into the metal oxide semiconductor layer. The buffer layer may for example be a silicon oxide layer (e.g. deposited by PECVD (Plasma Enhanced Chemical Vapour Deposition)) or an aluminium oxide layer (e.g. deposited by ALD (Atomic Layer Deposition)). The buffer layer typically has a thickness in the range between 50 nm and 200 nm, but the present disclosure in not limited thereto. A buffer layer may for example be deposited for providing improved smoothness, i.e. for providing a surface with a better smoothness than the surface of the underlying layer (such as e.g. the buffer layer). Layer stacks comprising multiple barrier layers and/or multiple buffer layers may be used.

On the substrate 10 with barrier and buffer layers 11, a bottom gate (BG) metallic layer or first gate metallic layer is deposited and patterned by means of photolithography to thereby form a first gate electrode or bottom gate electrode 12 (FIG 9, step 403). The area or region corresponding to the location of the first gate electrode or bottom gate electrode 12, in other words the area or region delimited by the first gate electrode 12, is further referred to as the gate region 120 (FIG 3). In the process flow 400 described here, the bottom gate patterning step is the first photolithographic (PL) step, comprising providing a photoresist layer, illuminating the photoresist layer and developing the illuminated resist (*PL#1*)*.* FIG 3 shows an example where the bottom gate electrode 12 has a rectangular shape with a wider portion at two opposite sides of the rectangle. This is only an example, and the present disclosure is not limited thereto. Other gate electrode shapes may be used.

The bottom gate metallic layer, i.e. the metallic layer for forming the first gate electrode or bottom gate electrode 12 may for example comprise Ti, Au, Mo, MoCr, TiN, Cu, W, AISi or TiW, the present disclosure not being limited thereto. The thickness may for example be in the range between 10 nm and 2 micrometer, the present disclosure not being limited thereto. It may for example be deposited by PVD (Physical Vapour Deposition), PECVD or evaporation, the present disclosure not being limited thereto. It may be a single layer or a layer stack comprising at least two layers.

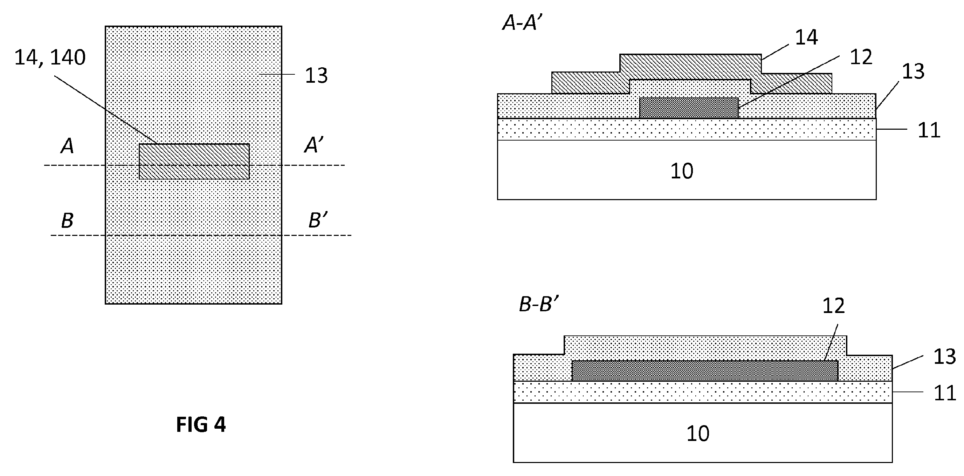

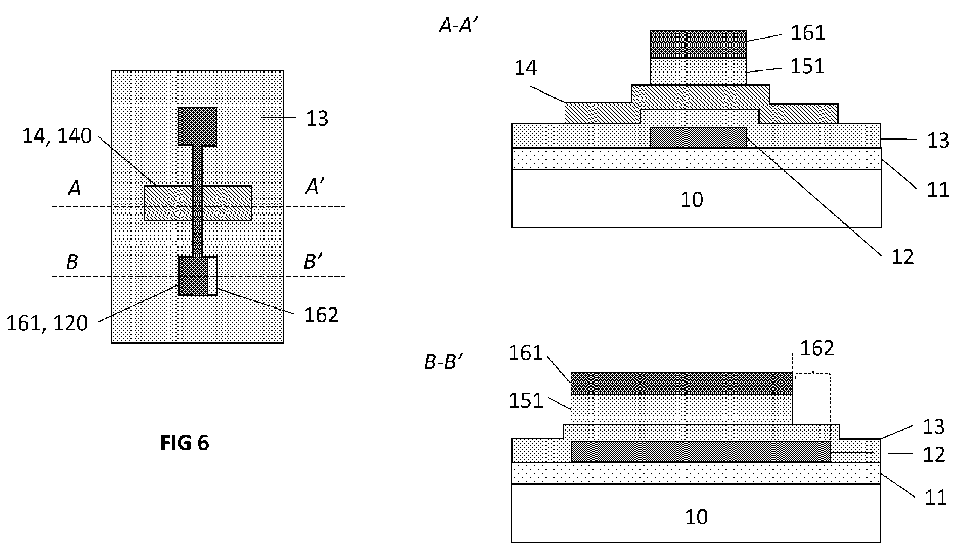

In a next step, as illustrated in FIG 4, a first gate dielectric layer or bottom gate dielectric layer 13, such as for example a silicon oxide layer, an aluminium oxide layer or a hafnium oxide layer, is deposited (FIG 9, step 404), such as for example by means of PECVD, PVD, ALD or solution processing. The thickness of the bottom gate dielectric layer 13 is typically in the range between 25 nm and 500 nm, the present disclosure not being limited thereto. On top of the bottom gate dielectric layer 13 an amorphous metal oxide semiconductor layer, such as for example an amorphous IGZO layer is deposited (FIG 9, step 405), for example by PVD (such as e.g. DC sputtering or evaporation), PECVD, ALD or solution processing. The amorphous metal oxide semiconductor layer is then patterned (FIG 9, step 405) by means of photolithography and wet or dry etching, thereby forming a patterned metal oxide semiconductor layer 14, resulting in a structure as schematically shown in FIG 4. The area or region corresponding to the location of the patterned metal oxide semiconductor layer 14, in other words the area or region delimited by the patterned metal oxide semiconductor layer 14, is further referred to as the semiconductor region 140 (FIG 4). The semiconductor region 140 is partially overlapping with part of the gate region (120) and extends beyond two opposite edges of the gate region (120) (FIG 6). In the process flow 400 described here, this metal oxide semiconductor layer patterning step is the second photolithographic (PL) step, comprising providing a photoresist layer, illuminating the photoresist layer and developing the illuminated resist (*PL*#*2*).

In embodiments of the present disclosure, the amorphous metal oxide semiconductor layer 14 may for example comprise gallium-indium-zinc-oxide (GIZO or IGZO), or other metal oxide based semiconductors, e.g. of following compositions (without indication of the stoichiometry): ZnO, ZnSnO, InO, InZnO, InZnSnO, LaInZnO, GaInO, HfInZnO, MgZnO, LaInZnO, TiO, TiInSnO, TiInZnO, ScInZnO, SiInZnO and ZrInZnO, ZrZnSnO. However, the present disclosure is not limited thereto and the method in one aspect can be used with other suitable metal oxide semiconductors known to a person skilled in the art. These semiconductor layers can be provided by a multitude of methods such as for example sputtering, thermal evaporation, pulsed laser deposition, and spin-casting, ink-jet printing or drop casting of precursor solutions. In embodiments of the present disclosure, the metal oxide semiconductor layer may have a thickness between 5 nm and 100 nm, for example between 10 nm and 50 nm, the present disclosure not being limited thereto.

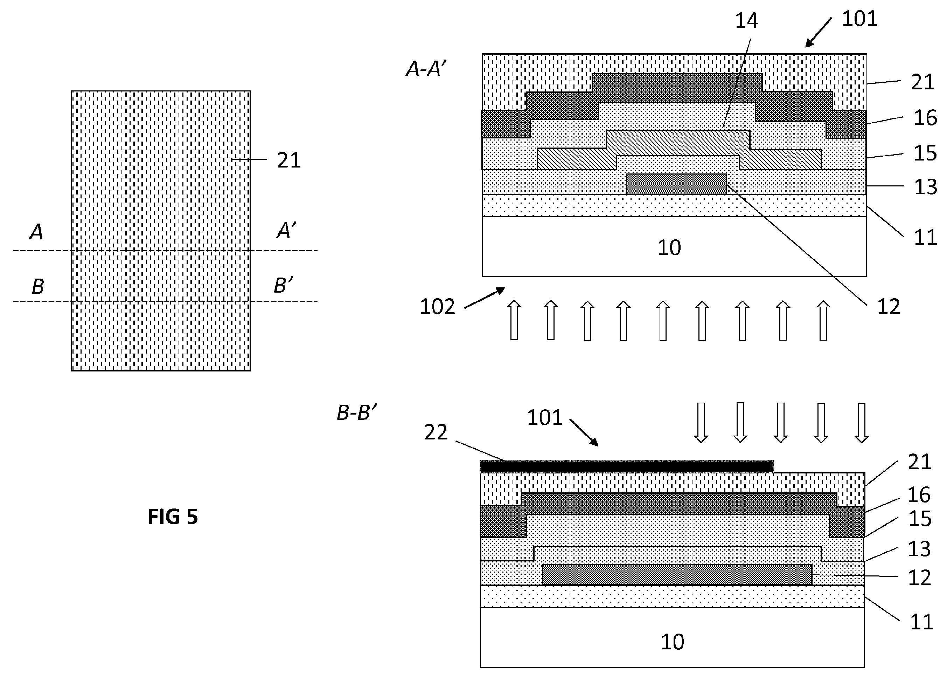

Next, a second gate dielectric layer or top gate (TG) dielectric layer 15, such as for example a silicon oxide layer, an aluminium oxide layer or a hafnium oxide layer, is deposited (FIG 9, step 406), such as for example by means of PECVD, PVD, ALD or solution processing. The thickness of the second gate dielectric layer 15 is typically in the range between 25 nm and 500 nm, the present disclosure not being limited thereto. On the second gate dielectric layer 15 a second gate electrically conductive layer or top gate electrically conductive layer 16 is deposited (FIG 9, step 407), for forming a second gate electrode or top gate electrode of the thin film transistor 100. In embodiments of the present disclosure the top gate electrically conductive layer 16 is an electrically conductive layer that is substantially transparent to the wavelength used in the lithographic step for patterning the top gate electrically conductive layer 16 to thereby define a second gate electrode or top gate electrode (as described below). Examples of materials that may be used for forming the top gate electrically conductive layer 16 are ITO (Indium Tin Oxide), AZO (Aluminium doped Zinc Oxide) and TiN, the present disclosure not being limited thereto. The thickness of the top gate electrically conductive layer 16 is selected such that the layer is sufficiently transparent to the wavelength of the light used in the subsequent photolithographic step. For example, for an ITO layer 16 the thickness may be in the range between 10 nm and 100 nm. For example, for a TiN layer 16 the thickness is preferably not larger than 50 nm. In the process flow 400 shown as an example in FIG 9, next a positive photoresist layer 21 is provided (FIG 9, step 408) on the top gate electrically conductive layer 16. This is schematically illustrated in FIG 5.

Next, the photoresist layer 21 is patterned (FIG 9, step 408) by performing two illumination steps of the positive photoresist layer 21, as schematically illustrated in FIG 5, followed by a step of developing the illuminated photoresist layer to thereby form a patterned photoresist layer. This patterning process comprises a rear side illumination step (as for example illustrated in FIG 1, step 207a) and a front side illumination step (as for example illustrated in FIG 1, step 207b). The structure shown in FIG 5 is illuminated from the rear side 102 of the substrate 10 (i.e. from the substrate side of the structure, i.e. the side opposite to the side where the layer stack and the photoresist layer 21 are provided) without using any dedicated mask. During this illumination step, the bottom gate electrode 12 has the function of a mask for the illumination. It is an advantage of using the bottom gate electrode 12 as a mask that it allows forming a top gate electrode that is fully aligned with the bottom gate electrode. With the same photoresist layer 21 present, the structure is illuminated from the front side 101 using a mask 22 as illustrated in the cross section along line *B-B'* shown in FIG 5. This mask 22 is designed such that in an area corresponding to the gate region 120, only an edge part (162, shown FIG 6) is exposed to the light during illumination through the mask. In the example shown in the drawings, the edge part 162 is selected to be located such that within the gate region 120, it only overlaps with a part of a wider portion of the bottom gate. There is no overlap between the edge part 162 and the semiconductor region 140, i.e. the edge part 162 is only present in an area different from the area where the metal oxide semiconductor layer 14 is present. In embodiments of the present disclosure first the rear side illumination may be done and afterwards the front side illumination, or vice versa, first the front side illumination may be done and afterwards the rear side illumination. After having performed both illumination steps, the photoresist layer 21 is developed to form a patterned photoresist layer. Next the top gate electrically conductive layer or second gate electrically conductive layer 16 and the top gate dielectric layer or second gate dielectric layer 15 are patterned (FIG 9, step 409) by dry or wet etching, using the remaining patterned photoresist layer as an etching mask. In the process flow 400 described here, this top gate electrically conductive layer and top gate dielectric layer patterning step is the third photolithographic (PL) step, comprising providing a photoresist layer, illuminating the photoresist layer and developing the illuminated resist (*PL#3*)*.*

The resulting structure, showing the patterned top gate dielectric layer 151 and the top gate electrode or second gate electrode 161 (the patterned top gate electrically conductive layer 16) is schematically illustrated in FIG 6. In this structure, the top gate electrode 161 has the same shape as the bottom gate electrode 12, except for an edge part 162, where the top gate electrode 161 is not overlapping with the bottom gate electrode 12.

Next, FIG 9 step 410, a source region and a drain region are formed in the patterned metal oxide semiconductor layer 14. In embodiments of the present disclosure the source region and the drain region are self-aligned to the second gate electrode 161. Forming the source region and the drain region may for example comprise doping with hydrogen, implantation of dopants, plasma treatment or reduction of the metal oxide semiconductor material, using the second gate electrode as a mask. As further described, in advantageous embodiments of the present disclosure, the step of forming a source region and a drain region may be combined with, e.g. it may be a result of, performing the next process step 411 (FIG 9).

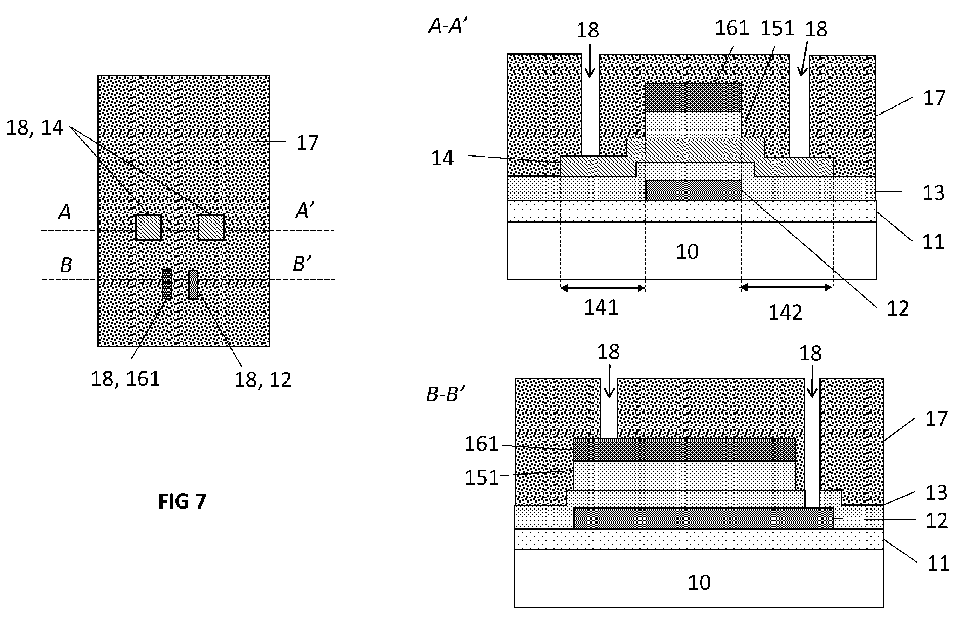

In the next process step, a dielectric layer 17 is deposited (FIG 9, step 411) as illustrated in FIG 7. The dielectric layer 17 may for example be a SiNₓ layer, e.g. having a thickness in the range between 50 nm and 500 nm. It may for example be deposited by PECVD. In a method according to embodiments of the present disclosure, the dielectric layer 17 may advantageously be a SiNₓ layer because the deposition of such a layer may result in hydrogen doping of the exposed regions (i.e. in regions not covered by top gate electrode 161) of the amorphous metal oxide semiconductor layer 14, thereby forming a source region 141 and a drain region 142 in the metal oxide semiconductor layer 14, as schematically illustrated in FIG 7. These exposed regions correspond to the regions where the top gate electrode 161 is not present. Therefore, this approach results in the formation of source and drain regions that are self-aligned to the top gate electrode 161. In embodiments of the present disclosure, other methods may be used for doping the exposed regions (i.e. the regions not covered by the top gate 161) of the amorphous metal oxide semiconductor layer 14, such as for example reduction of the metal oxide semiconductor material by means of Ca, Ti, Al; by implantation of dopants (e.g. B, P); or by treatment with an Ar or NF₃ plasma. A combination of different methods may be used. In embodiments of the present disclosure, the top gate electrode 161 is used as a mask for the doping step.

At step 412 of the process flow 400 (FIG 9) vias 18 are defined by photolithography and dry or wet etching through the dielectric layer 17, for simultaneous contact opening to the source region 141, the drain region 142, the top gate electrode 161 and to the bottom gate electrode 12. In the process flow 400 described here, this via formation step is the fourth photolithographic (PL) step, comprising providing a photoresist layer, illuminating the photoresist layer and developing the illuminated resist (*PL#4*)*.* It is an advantage of a method according to embodiments of the present disclosure that there is no overlap between the top gate electrode 161 and the bottom gate electrode 12 in an area corresponding to the edge part 162. As illustrated in FIG 7, this allows to form openings or vias simultaneously, i.e. using a single patterning step, towards the source region 141, the drain region 142, the top gate electrode 161 and the bottom gate electrode 12. This allows saving one photolithographic step as compared to known methods for fabricating fully self-aligned dual-gate thin film transistors.

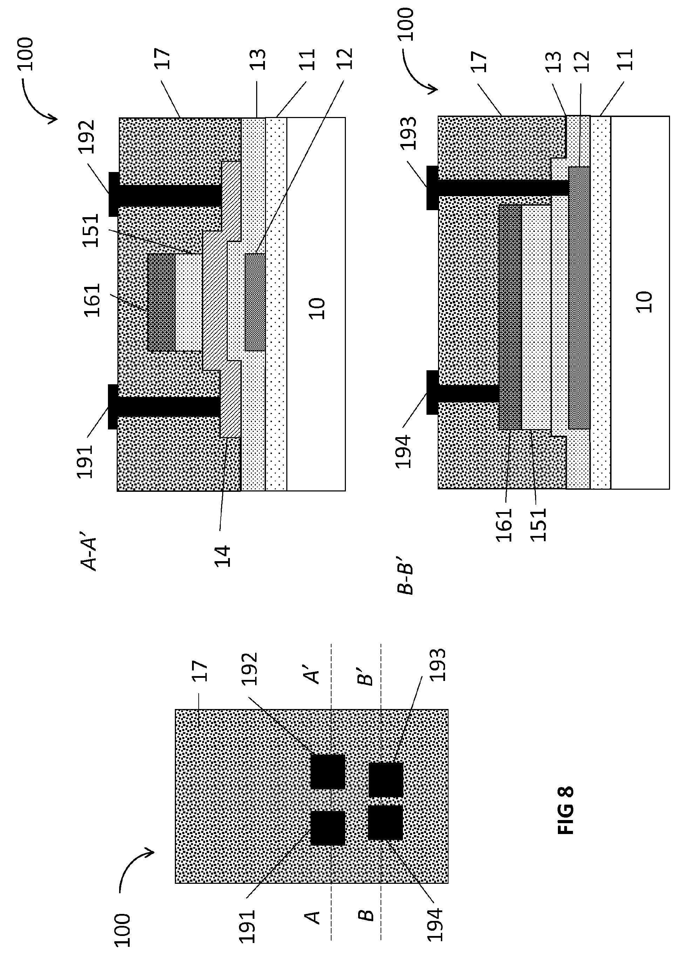

In a next step (FIG 9, step 413) an electrically conductive layer, e.g. a metal layer or an electrically conductive oxide layer, is deposited and patterned by photolithography and etching (e.g. dry etching) to thereby form a source contact 191, a drain contact 192, a top gate contact or second gate contact 194 and a bottom gate contact or first gate contact 193 as illustrated in FIG 8. The electrically conductive layer may for example contain Mo, MoCr, a Mo alloy, Al, W, Ti, TiN, Au or ITO, the present disclosure not being limited thereto. The thickness of this layer may for example be in the range between 50 nm and 500 nm, the present disclosure not being limited thereto. It may be a single layer or it may be a layer stack comprising at least two layers. In the process flow 400 described here, this contact or electrode formation step is the fifth photolithographic (PL) step, comprising providing a photoresist layer, illuminating the photoresist layer and developing the illuminated resist (*PL*#*5*). Finally the samples may be annealed, for example at a temperature in the range between 150°C and 450°C, e.g. between 200°C and 300°C, for example in a N₂, O₂ or air atmosphere for 1 to 12 hours.

The process flow 400 schematically illustrated in FIG 9 is only an example of a method for fabricating a fully self-aligned dual-gate thin film transistor according to an embodiment of the present disclosure. For example, in a method for fabricating a fully self-aligned dual-gate thin film transistor according to another embodiment of the present disclosure, the second gate electrically conductive layer may be provided after patterning the photoresist layer and patterning the second gate electrically conductive layer may comprise performing a lift-off process (as for example illustrated in FIG 2).

Dual-gate thin film transistor devices 100 were fabricated in accordance with an embodiment of a method 400 (FIG 9) of the present disclosure. On the top of a glass carrier substrate 10, a PECVD SiNₓ barrier layer was deposited, followed by Atomic Layer Deposition of a 100 nm thick Al₂O₃ buffer layer at 150°C (step 402). This was followed by the deposition of a 10 nm TiN / 50 nm AISi / 10 nm TiN layer stack and patterning of the stack using a sequence of dry and wet etching steps, to thereby form a first gate electrode or bottom gate electrode 12 (step 403). Next a first gate dielectric layer 13 consisting of 100 nm of Al₂O₃ was deposited (step 404) at 150°C, followed by sputter deposition of a 24 nm thick amorphous IGZO layer (step 405). The amorphous IGZO layer was patterned using wet etching (step 405). A 100 nm thick silicon oxide second gate dielectric layer 15 was then deposited (step 406) by means of PECVD at 250°C, followed by deposition (step 407) of a 25 nm thick TiN second gate electrically conductive layer 16. Subsequently, the gate stack comprising the second gate electrically conductive layer 16 and the second gate dielectric layer 15 was patterned (step 409) by bottom and top exposures of a photoresist layer (step 408) according to a method of the present disclosure. The pattering (step 409) was done using a sequence of dry etching steps (CF₄ and SF₆ chemistry). Afterwards, a 400 nm thick SiNₓ dielectric layer 17 was deposited (step 411) at 150°C by means of PECVD. Contact opening (step 412) was done using a sequence of dry and wet etching steps. This contact opening step was combined for both contacting the bottom gate electrode 12 and the top gate electrode 161, as well as the source region 141 and the drain region 142. Next a 10 nm Ti /80 nm AISi /10 nm Ti stack was deposited and patterned (step 413) using dry and wet etching steps, to thereby form a source contact 191, a drain contact 192, a bottom gate contact 193 and a top gate contact 194. Finally, the samples were annealed at 250°C in a N₂ atmosphere for 1 hour.

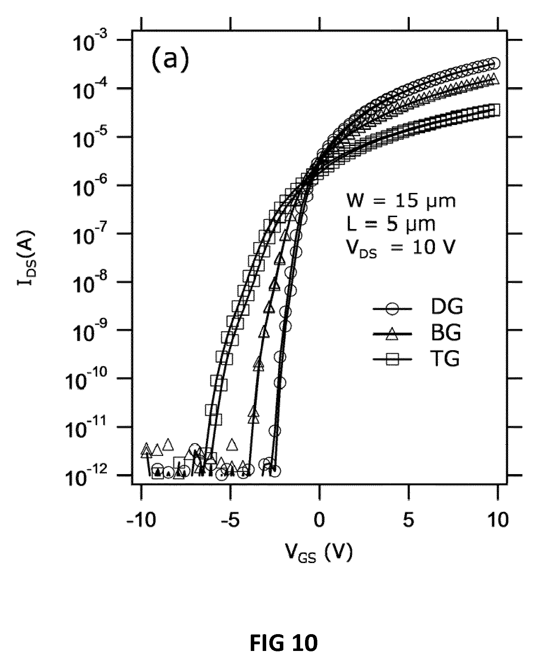

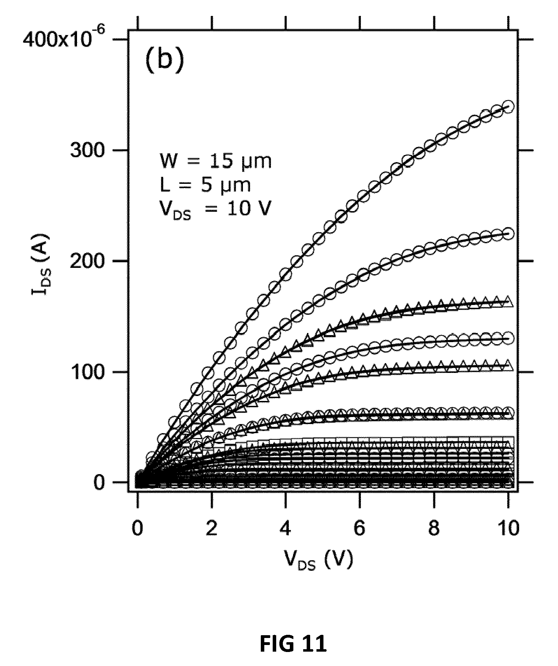

FIG 10 shows I_{DS} versus V_{GS} transfer characteristics at V_{DS} = 10 V and FIG 11 shows I_{DS} versus V_{DS} output characteristics at V_{GS} = 10 V as measured for the dual-gate thin film transistor fabricated as described above (circles). The transistors had a W/L ratio of 15 micrometer /5 micrometer. As a reference, similar characteristics are shown for the same device, but wherein during the measurement only the back gate is used (triangles) and wherein during the measurement only the top gate is used (squares) respectively. The dual-gate TFTs of the present disclosure show a steeper sub-threshold slope SS⁻¹ and a higher on-current I_{ON} when compared to single gate TFTs. In addition, a turn-on voltage V_{ON} close to zero Volt is obtained for the dual-gate TFT of the present disclosure. An overview of the measured SS⁻¹, I_{ON} and V_{ON} values is given in Table 1.

**Table 1**

| **measurement** | **SS**^{**-**1}[V/decade] | **I_{ON}**[10⁻⁶ A] | **V_{ON}**[V] |
|---|---|---|---|
| **dual gate** | 0.24 | 332 | -2.8 |
| **back gate only** | 0.39 | 158 | -6.4 |
| **top gate only** | 0.29 | 36 | -4.0 |

The foregoing description details certain embodiments of the disclosure. It will be appreciated, however, that no matter how detailed the foregoing appears in text, the disclosure may be practiced in many ways. It should be noted that the use of particular terminology when describing certain features or aspects of the disclosure should not be taken to imply that the terminology is being re-defined herein to be restricted to including any specific characteristics of the features or aspects of the disclosure with which that terminology is associated.

It is to be understood that although preferred embodiments, specific constructions and configurations, as well as materials, have been discussed herein for devices according to the present disclosure, various changes or modifications in form and detail may be made. For example, steps may be added or deleted to methods described within the scope of the present disclosure.

Whereas the above detailed description as well as the summary of the disclosure has been focused on a method for fabricating a device, the present disclosure also relates to a device obtained using a method according to any of the embodiments as described above.

## Claims

1. A method (200, 300, 400) for fabricating a fully self-aligned dual-gate metal oxide semiconductor thin film transistor (100), the method comprising:
providing (201, 301, 403) on a front side (101) of a substrate (10) a first gate electrode (12) delimiting a gate region (120);
providing (202, 302, 404) a first gate dielectric layer (13) over the substrate (10) and the first gate electrode (12);
providing (203, 303, 405) a patterned metal oxide semiconductor layer (14) on the first gate dielectric layer (13), the patterned metal oxide semiconductor layer (14) delimiting a semiconductor region (140) partially overlapping with part of the gate region (120) and extending beyond two opposite edges of the gate region (120);
providing (204, 304, 406) a second gate dielectric layer (15) over the patterned metal oxide semiconductor layer (14);
providing (205, 305, 407) a second gate electrically conductive layer (16);
providing (206, 306, 408) a photoresist layer (21);
patterning (207, 307, 408) the photoresist layer (21) by performing a rear side illumination step (207a, 307a), a front side illumination step (207b, 307b) and a photoresist development step (207c, 307c), thereby forming a patterned photoresist layer, wherein the rear side illumination step (207a, 307a) comprises illumination of the photoresist layer (21) from a rear side (102) of the substrate (10) using the first gate electrode (12) as a mask, and wherein the front side illumination step (207b, 307b) comprises illumination of the photoresist layer (21) from the front side (101) using a mask (22) exposing the photoresist layer (21) in the gate region (120) only in an edge part (162);
patterning (208, 308, 409) the second gate electrically conductive layer (16),
thereby forming a second gate electrode (161); and
patterning (209, 309, 409) the second gate dielectric layer (15), thereby forming a patterned second gate dielectric layer (151).

2. The method (200, 400) according to claim 1, wherein providing (205, 407) the second gate electrically conductive layer (16) is done before providing (206, 308) the photoresist layer (12), wherein patterning (208, 409) the second gate electrically conductive layer (16) comprises locally etching the second gate electrically conductive layer (16) using the patterned photoresist layer as a mask, and wherein patterning (209, 409) the second gate dielectric layer (15) comprises locally etching the second gate dielectric layer (15) using the patterned photoresist layer or the second gate electrode (161) as a mask.

3. The method (300) according to claim 1, wherein providing (305) the second gate electrically conductive layer (16) is done after patterning (307) the photoresist layer (12), wherein patterning (308) the second gate electrically conductive layer (16) comprises performing a lift-off process, and wherein patterning (309) the second gate dielectric layer (15) comprises locally etching the second gate dielectric layer (15) using the second gate electrode (161) as a mask.

4. The method (200, 300, 400) according to any of the previous claims, wherein the edge part (162) is located in a part of the gate region (120) that is non-overlapping with the semiconductor region (140).

5. The method (400) according to any of the previous claims, further comprising:
providing (410) a source region (141) and a drain region (142) in the patterned metal oxide semiconductor layer (14), wherein the source region (141) and the drain region (142) are self-aligned to the second gate electrode (161).

6. The method (400) according to claim 5, wherein providing (410) the source region (141) and the drain region (142) comprises doping with hydrogen.

7. The method (400) according to claim 5, wherein providing (410) the source region (141) and the drain region (142) comprises implantation of dopants or plasma treatment or reduction of the metal oxide semiconductor material.

8. The method (400) according to any of claims 5 to 7, the method further comprising:
depositing (411) a dielectric layer (17); and
forming (412) vias (18) through the dielectric layer (17) simultaneously towards the source region (141), the drain region (142), the second gate electrode (161) and the first gate electrode (12).

9. The method (400) according to claim 8, wherein depositing (411) the dielectric layer (17) comprises depositing a silicon nitride layer, wherein the step of depositing the silicon nitride layer introduces hydrogen in the metal oxide semiconductor layer (14), thereby doping the metal oxide semiconductor layer (14) with hydrogen and forming the source region (141) and the drain region (142).

10. The method (400) according to claim 9, wherein depositing (411) the silicon nitride layer comprises depositing the silicon nitride layer by means of Plasma Enhanced Chemical Vapour Deposition.

11. The method (400) according to any of claims 5 to 10, further comprising depositing and patterning (413) an electrically conductive layer, thereby simultaneously forming a source contact (191), a drain contact (192), a first gate contact (193) and a second gate contact (194).
